**Europäisches Patentamt**

**European Patent Office**

**Office européen des brevets**

(11) Veröffentlichungsnummer: **0 476 320 A1**

# EUROPÄISCHE PATENTANMELDUNG

(21) Anmeldenummer: **91113828.7**

(22) Anmeldetag: **17.08.91**

(51) Int. Cl.5: **H05K 3/02**, H05K 3/10, H01L 21/48

(30) Priorität: **18.09.90 DE 4029522**

(43) Veröffentlichungstag der Anmeldung:
**25.03.92 Patentblatt 92/13**

(84) Benannte Vertragsstaaten:
**AT CH DE FR GB IT LI**

(71) Anmelder: **ROBERT BOSCH GmbH**
**Postfach 30 02 20**
**W-7000 Stuttgart 30(DE)**

(72) Erfinder: **Wulff, Dietrich, Dipl.-Ing.**
**Veilchenweg 10**
**W-7143 Vaihingen/Enz(DE)**
Erfinder: **Gruenwald, Werner, Dipl.-Phys.**
**Roemerweg 8**
**W-7016 Gerlingen(DE)**
Erfinder: **Schmid, Kurt**
**Schloss Strasse 55**
**W-7257 Ditzingen(DE)**

(54) **Verfahren zur Herstellung von leitfähigen Strukturen in Dickschichttechnik.**

(57) Es wird ein Verfahren zur Herstellung von leitfähigen Strukturen, insbesondere Leiterbahnstrukturen, in Dickschichttechnik auf einem Substrat vorgeschlagen, bei dem zunächst eine metallhaltige Paste flächendeckend auf das Substrat aufgebracht und dann getrocknet wird. Die vorgesehene leitfähige Struktur wird dann durch Einbrennen mittels eines entsprechend gesteuerten Laserstrahls gebildet. Schließlich wird das Substrat zur Entfernung der Paste von den nicht vom Laserstrahl behandelten Flächen gereinigt. Hierdurch kann gegenüber den bisherigen Verfahren ein Arbeitsschritt eingespart werden, da der Laserstrahl gleichzeitig den Einbrennvorgang vornimmt und die Gestalt der leitfähigen Strukturen erzeugt.

EP 0 476 320 A1

## Stand der Technik

Die Erfindung betrifft ein Verfahren zur Herstellung von leitfähigen Strukturen in Dickschichttechnik auf einem Substrat, bei dem eine metallhaltige Paste auf das Substrat aufgebracht und eingebrannt wird.

Zur Herstellung derartiger leitfähiger Strukturen, z.B. von Leiterbahnen oder Leiterbahnanschlüssen, ist es bekannt, eine Schicht aus metallhaltiger Paste auf ein Substrat aufzubringen und einzubrennen. Danach werden die gewünschten feinen leitfähigen Strukturen mittels eines Laserstrahls hergestellt, indem dieser die aufgebrannten Metallschichten auftrennt und/oder verdampft. Der Nachteil des bekannten Verfahrens besteht darin, daß zum einen eine Vielzahl von Arbeitsschritten erforderlich ist, und daß zum anderen jeweils wesentlich größere Metallschichten aufgebracht werden müssen, als dies für die Funktion erforderlich wäre. Insbesondere bei sehr wertvollen Metallschichten, wie Gold- oder Platinschichten, stellt das Auf- und Wegbrennen eine kostspielige Materialverschwendung dar.

## Vorteile der Erfindung

Das erfindungsgemäße Verfahren mit den kennzeichnenden Merkmalen des Hauptanspruchs hat den Vorteil, daß gegenüber dem bisherigen Verfahren ein Arbeitsschritt eingespart werden kann, da der Laserstrahl das Einbrennen und gleichzeitig das Herstellen der gewünschten Struktur ermöglicht. Darüber hinaus werden nur diejenigen Bereiche der aufgebrachten metallhaltigen Paste eingebrannt, die tatsächlich benötigt werden. Die übrige Paste kann wieder abgewaschen und wiederverwendet werden, so daß eine bessere Materialausnutzung erreicht werden kann. Zusätzlich wird das Aufbringen der Paste erleichtert, da diese nunmehr flächendeckend aufgebracht werden kann. Ein weiterer wesentlicher Vorteil ist die Herstellbarkeit von sehr feinen Strukturen.

Durch die in den Unteransprüchen aufgeführten Maßnahmen sind vorteilhafte Weiterbildungen und Verbesserungen des im Anspruch 1 angegebenen Verfahrens möglich.

Als metallhaltige Paste wird zweckmäßigerweise ein Resinat verwendet, wobei der Metallgehalt darin im wesentlichen aus Gold, Silber und/oder Platin in gelöster Form besteht. Als Substrat wird dabei eine Keramik oder ein emaillierter Stahl verwendet.

Für die Trocknung hat es sich als günstig erwiesen, das mit der Raste versehene Substrat einer Temperatur von 100 - 140° C während einer Zeit von 5 - 30 Minuten auszusetzen, insbesondere einer Temperatur von 120° C während einer Zeit von 10 Minuten.

Da zum Einbrennen die Raste lediglich erhitzt werden muß, wird die Laserleistung gegenüber den in der Dickschichttechnik üblichen, zum Widerstandsabgleich verwendeten Leistungen reduziert. Hierzu kann in einfacher Weise ein Filter in den Strahlengang gebracht werden, wodurch die Leistung sehr fein eingestellt werden kann. Zur intensiven Reinigung und zur vollständigen Ablösung der nicht verbrauchten Raste wird diese in einem Lösungsmittel enthaltenden Ultraschallbad durchgeführt, wobei als Lösungsmittel vor allem Azeton geeignet ist.

Wenn höhere Leitfähigkeiten der aufgebrachten Strukturen benötigt werden, so kann eine Nachverstärkung durch Eintauchen in eine Metallösung oder galvanisch durchgeführt werden.

Das erfindungsgemäße Verfahren wird im folgenden in seiner chronologischen Reihenfolge detailliert beschrieben.

Zunächst wird ein Substrat, z.B. eine Keramik, ein emaillierter Stahl oder ein sonstiges beschichtetes Metallplättchen, mit einer Resinatpaste flächendeckend durch Aufdrucken überzogen und anschließend etwa 10 Minuten bei 120° C getrocknet. Die Zeiten und die Temperatur können selbstverständlich in Abhängigkeit der verwendeten Resinatpaste oder des verwendeten Substrats variieren. Als Resinatpaste kann insbesondere Gold-, Silberund/oder PlatinResinat verwendet werden. Es ist auch möglich, eine andere metallhaltige Paste zu verwenden.

Auf dieser getrockneten Schicht wird nun direkt die zu erzeugende und gewünschte Leiterbahnstruktur mittels eines Laserstrahls eingebrannt. Der Laserstrahl kann dabei entweder pendelnde oder schneckenförmige Bewegungen ausführen, um die gewünschten Metallflächen zu erzeugen. Diese können durchgehend oder gitterartig strukturiert sein. Auf diese Weise lassen sich beliebige Muster von Leiterbahnen oder Leiterbahnanschlüssen erzeugen.

Für den Einbrennvorgang muß die Laserleistung gegenüber dem in der Dickschichttechnik üblichen, zum Widerstandsabgleich verwendeten Leistungen reduziert werden, damit gleichmäßige Schichten entstehen und das Metall nicht verdampft. Diese Reduzierung der Laserleistung kann zum einen dadurch erfolgen, daß die Laserleistung elektrisch reduziert wird oder daß ein Laser mit einer geringeren Leistung verwendet wird. Es ist jedoch auch möglich, die Leistungsreduzierung durch zusätzlich in den Strahlengang eingebrachte Filter vorzunehmen. Durch die Anordnung mehrerer Filter hintereinander kann so die Leistung fein abgestuft eingestellt werden. Die Schreib- bzw. Einbrenngeschwindigkeit liegt bei ca. 5 mm/s.

Nach dem Einbrennvorgang wird der nicht eingebrannte Teil der Resinatpaste, also die Paste auf denjenigen Flächen, die nicht vom Laserstrahl überstrichen worden sind, mit einem Lösungsmittel im Ultraschallbad abgewaschen. Als Lösungsmittel eignet sich vor allem Azeton. Nach der Reinigung bleibt die durch den Laserstrahl eingebrannte und direkt erzeugte Struktur bestehen. Die ausgewaschene Resinatpaste kann aufbereitet und wiederverwendet werden.

Die mit Goldresinat erreichten Leiterbahnbreiten liegen bei ca. 50 $\mu$m.

Durch das beschriebene Verfahren können feine, im Semi-Additiv-Verfahren aufgebrachte Strukturen vergleichsweise kostengünstig hergestellt werden. Die dünnen, schmalen Resinatschichten weisen zunächst einen hohen elektrischen Widerstand auf. Dies ist beispielsweise bei der Herstellung von Temperaturfühlern ein Vorteil, da sich ein geringer Flächenbedarf beispielsweise für ein Pt-100- oder ein Pt-1000-Element ergibt. Wo höhere Leitfähigkeiten benötigt werden, kann eine Nachverstärkung durch Eintauchen in eine Metallösung oder galvanisch erfolgen.

**Patentansprüche**

1. Verfahren zur Herstellung von leitfähigen Strukturen in Dickschichttechnik auf einem Substrat, bei dem eine metallhaltige Paste auf das Substrat aufgebracht und eingebrannt wird, dadurch gekennzeichnet, daß die Paste flächendeckend auf das Substrat aufgebracht und getrocknet wird, daß dann die vorgesehene leitfähige Struktur durch Einbrennen mittels eines entsprechend gesteuerten Laserstrahls gebildet wird und daß schließlich das Substrat zur Entfernung der Paste von den nicht vom Laserstrahl behandelten Flächen gereinigt wird.

2. Verfahren nach Anspruch 1, dadurch gekennzeichnet, daß als metallhaltige Paste ein Resinat verwendet wird.

3. Verfahren nach Anspruch 1 oder 2, dadurch gekennzeichnet, daß der Metallgehalt in der Paste aus Gold, Silber und/oder Platin besteht.

4. Verfahren nach einem der vorhergehenden Ansprüche, dadurch gekennzeichnet, daß die Paste flächendeckend aufgedruckt wird.

5. Verfahren nach einem der vorhergehenden Ansprüche, dadurch gekennzeichnet, daß als Substrat eine Keramik oder ein emaillierter Stahl verwendet wird.

6. Verfahren nach einem der vorhergehenden Ansprüche, dadurch gekennzeichnet, daß das Substrat zur Trocknung der Paste einer Temperatur von 100 - 140° C während einer Zeit von 5 - 30 Minuten ausgesetzt wird.

7. Verfahren nach einem der vorhergehenden Ansprüche, dadurch gekennzeichnet, daß die Laserleistung des den Laserstrahl erzeugenden Lasers gegenüber den in der Dickschichttechnik üblichen, zum Widerstandsabgleich verwendeten Leistungen reduziert wird.

8. Verfahren nach Anspruch 7, dadurch gekennzeichnet, daß zur Leistungsreduzierung wenigstens ein Filter in den Strahlengang gebracht wird.

9. Verfahren nach einem der vorhergehenden Ansprüche, dadurch gekennzeichnet, daß die Reinigung in einem ein Lösungsmittel enthaltenden Ultraschallbad durchgeführt wird.

10. Verfahren nach Anspruch 9, dadurch gekennzeichnet, daß das Lösungsmittel Azeton ist.

11. Verfahren nach einem der vorhergehenden Ansprüche, dadurch gekennzeichnet, daß eine Nachverstärkung der erzeugten Strukturen durch Eintauchen in eine Metallösung oder galvanisch durchgeführt wird.

12. Verfahren nach einem der vorhergehenden Ansprüche, dadurch gekennzeichnet, daß die erzeugten Strukturen Leiterbahnstrukturen sind.

**Europäisches Patentamt**

# EUROPÄISCHER RECHERCHENBERICHT

Nummer der Anmeldung

**EP 91 11 3828**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-2 098 807 (FERRANTI LTD) <br> * Seite 1, Zeile 118 - Seite 2, Zeile 19 * * * Seite 2, Zeile 51 - Zeile 62 * * | 1-5,9,12 | H 05 K 3/02 <br> H 05 K 3/10 <br> H 01 L 21/48 |
| X | GB-A-1 251 451 (SECRETARY OF STATE FOR DEFENCE) <br> * das ganze Dokument * * | 1-5,9,12 | |
| X | US-A-4 942 110 (GENOVESE ET AL.) <br> * Ansprüche * * | 1,4,9,12 | |
| X | US-A-4 931 323 (MANITT ET AL.) <br> * Spalte 2, Zeile 40 - Zeile 64 * * | 1,4-6,9, 10,12 | |
| X | DE-A-3 629 474 (LICENTIA PATENT-VERWALTUNGS-GMBH) <br> * das ganze Dokument * * | 1,4,5,9,12 | |
| X | PATENT ABSTRACTS OF JAPAN vol. 11, no. 88 (E-490)18. März 1987 <br> & JP-A-61 240 667 ( SOSHIN DENKI KK ) 25. Oktober 1986 <br> * Zusammenfassung * * | 1,4,5,9,12 | |
| A | US-A-3 615 457 (SEIBERT ET AL.) <br> * Spalte 1, Zeile 68 - Spalte 2, Zeile 2 * * * Spalte 3, Zeile 19 - Zeile 52 * * | 1-5,9,12 | **RECHERCHIERTE SACHGEBIETE (Int. Cl.5)** <br><br> H 05 K <br> H 01 L |
| A | EP-A-0 266 877 (ENGELHARD CORP.) <br> * Ansprüche 1,2,5,7,16 * * | 1-6,11,12 | |
| A | IBM TECHNICAL DISCLOSURE BULLETIN. Bd. 31, Nr. 11, April 1989, NEW YORK US Seiten 168 - 169; 'Method for laser direct writing of PWB circuit patterns using thick film conductive pastes' <br> * das ganze Dokument * * | 1,3,5-7 | |

Der vorliegende Recherchenbericht wurde für alle Patentansprüche erstellt

| Recherchenort | Abschlußdatum der Recherche | Prüfer |
|---|---|---|
| Den Haag | 13 Dezember 91 | MES L.A. |